Europäisches Patentamt

European Patent Office

Office européen des brevets

(19)

(11) Veröffentlichungsnummer: **0 172 484**
**B1**

(12) **EUROPÄISCHE PATENTSCHRIFT**

(45) Veröffentlichungstag der Patentschrift: **05.12.90**

(21) Anmeldenummer: **85109824.4**

(22) Anmeldetag: **05.08.85**

(51) Int. Cl.⁵: **H 01 L 31/075,**
H 01 L 31/0216

(54) **Solarzelle mit einem aus amorphem Silizium bestehenden Halbleiterkörper der Schichtenfolge p-i-n.**

(30) Priorität: **07.08.84 DE 3429088**

(43) Veröffentlichungstag der Anmeldung:
**26.02.86 Patentblatt 86/09**

(45) Bekanntmachung des Hinweises auf die
Patenterteilung:
**05.12.90 Patentblatt 90/49**

(84) Benannte Vertragsstaaten:
**DE FR GB IT**

(56) Entgegenhaltungen:
EP-A-0 111 749
GB-A-2 130 008
GB-A-2 135 510
US-A-4 409 424
JOURNAL OF APPLIED PHYSICS, Band 54, Nr.
11, November 1983, Seiten 6705-6707, American
Institute of Physics, New York, US; P.
Sichanugrist et al.: "Amorphous silicon solar
cells with graded boron-doped active layers"

(73) Patentinhaber: **Siemens Aktiengesellschaft**
**Wittelsbacherplatz 2**
**D-8000 München 2 (DE)**

(72) Erfinder: **Kausche, Helmold, Dipl.-Phys.**
**Tessinerstrasse 146**
**D-8000 München 71 (DE)**

(56) References cited:
**APPLIED PHYSICS LETTERS, Band 44, Nr. 11, 1.**
**Juni 1984, New York, US; T. MATSUSHITA et**
**al.: "High performance hydrogenated**
**amorphous Si solar cells with graded boron-**
**doped intrinsic layers prepared from disilane at**
**high deposition rates"**
**PATENTS ABSTRACTS OF JAPAN, Band 7, Nr.**
**36 (E-158) 1181r, 15. Februar 1983; & JP - A - 57**
**187 972 (KOGYO GIJUTSUIN) 18.11.1982**
**SOLAR CELLS, Band 9, Nr. 1/2, Juni-Juli 1983,**
**Seiten 3-12, Elsevier Sequoia, NL; Y. UCHIDA et**
**al.: "Stability of P-I-N hydrogenated amorphous**
**silicon solar cells to light exposure"**

## Beschreibung

Die Erfindung betrifft eine Solarzelle mit einem aus amorphem Silizium bestehenden Halbleiterkörper der Schichtenfolge p-i-n mit einer aus Metall bestehenden, als Substrat dienenden Rückseitenkontaktelektrode und mit einer aus Zinnoxid-Indiumoxid bestehenden Antireflexschicht, die auf der Lichteinfallseite unterhalb der als Metallstreifensystem ausgebildeten Vorderseitenkontaktelektrode angeordnet ist.

Eine solche Solarzelle ist beispielsweise aus EP—A—0 111 749 bekannt. Die dort beschriebene Solarzelle wird von der n-Seite her bestrahlt.

Bei Dünnschichtsolarzellen aus amorphem Silizium (a-Si) mit der Schichtenfolge p-i-n kann das Licht sowohl durch die p-Seite als auch die n-Seite eingestrahlt werden. Diese Zellen zeigen mehr oder weniger ausgeprägt den sogenannten Staebler-Wronski-Effekt. Durch diesen Effekt kann bei Beleuchtung, vor allen Dingen, wenn die Zelle offen betrieben wird, also die Leerlaufspannung anliegt, eine reversible Abnahme des Wirkungsgrades, zum Beispiel bis zu 50% bei einer Beleuchtung von 100 mW/cm$^2$ mit einer Zeitdauer von 16 Stunden erfolgen. Reversibel bedeutet hier, daß durch eine Temperung der Anordnung bei zum Bespiel 180°C nach 30 Minuten die Ausgangswerte des Wirkungsgrades wieder erreicht werden. Obwohl die Abnahme des Wirkungsgrades sich mit der Zeit verringert, sind derartige Zellen für den technischen Einsatz nur bedingt brauchbar.

Aufgabe der Erfindung ist es daher, die eben beschriebene Lichtalterung zu verhindern und eine stabile, den Staebler-Wronski-Effekt nicht ausweisende Solarzelle zu schaffen.

Diese Aufgabe wird durch eine Solarzelle der eingangs genannten Art dadurch gelöst, daß der zwischen Rückseitenkontaktelektrode und Antireflexschicht angeordnete Halbleiterkörper in der intrinsic-Schicht ein Borprofil mit in Richtung n-Schicht abnehmender Borkonzentration aufweist und die n-Schicht der Antireflexschicht benachbart ist.

Es liegt im Rahmen der Erfindung, daß die Borkonzentration im amorphen Silizium am p-i-Übergang von 40 ppm zum i-n-Übergang bis auf 0 ppm abnimmt. Ein entsprechender Borkonzentrationsgradient stellt sich im amorphen Silizium ein. Da die intrinsic-Schicht in einer getrennten Glimmentladungs-Abscheidekammer hergestellt wird, fällt durch diese Maßnahme die Verschleppung von Bor nicht mehr ins Gewicht. Im Reaktionsgas wird der Boranteil auf 20 ppm Diboran (B$_2$H$_6$) in bezug auf das Reaktionsgas Silan (SiH$_4$) eingestellt.

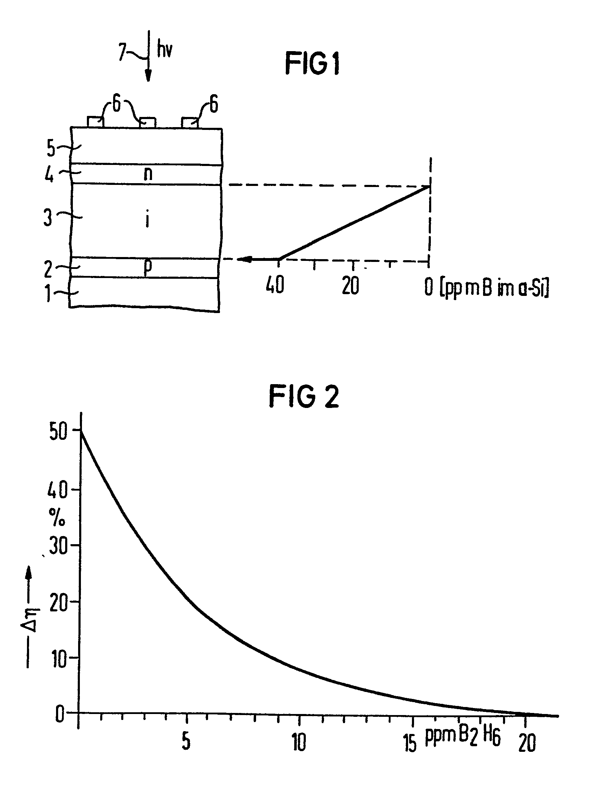

Die Erfindung wird im folgenden anhand der Figuren 1 und 2 noch näher erläutert. Dabei zeigt

die Figur 1 schematisch den Aufbau der Solarzelle mit nebenstehendem, beispielsweise linearem Bordotierungsprofil und

die Figur 2 in einem Diagramm die Abnahme des Wirkungsgrades (−Δη) in Prozent (Ordinate) durch eine 16 stündige 100 mW/cm$^2$-Beleuchtung

ohne Lastwiderstand (Staebler-Wronski-Effekt) in Abhängigkeit von der Borkonzentration; (die Abszisse zeigt en Anfangswert am p-i-Übergang von Diboran im Silan).

In Figur 1 gelten folgende Bezugszeichen:
1=Substratkörper zum Beispiel aus Edelstahl,
2=amorphe Siliziumschicht p-dotiert (20 nm),
3=amorphe Siliziumschicht intrinsic mit Borprofil (500 nm),
4=amorphe Siliziumschicht n-dotiert (15 nm),
5=Indiumoxid-Zinnoxid-Schicht (=ITO, Antireflexschicht, 70 nm)
6=Metallstreifensystem bestehend aus einer Chrom-Nickel-Legierung, einer zum Beispiel aus Silber bestehenden Zwischenschicht und einer Zinnschicht,
7=Richtung der einfallenden Strahlen (hv).

Wie aus der Figur 2 zu entnehmen ist, zeigt die Lichtalterung von Zellen ohne Lastwiderstand und mit dem linearen Bordotierungsprofil in der intrinsic-Schicht nur Änderungen des Wirkungsgrades η im Bereich der Meßgenauigkeit (absolute Abweichung: ca.±0,1%).

Der Wirkungsgrad ist zwar nicht so hoch wie der beispielsweise aus J. Appl. Phys. *54* (11) auf den Seiten 6705 bis 6707 oder aus Appl. Phys. Letters *44* (11) auf den Seiten 1092 bis 1094 bekannten Zellen mit Bordotierungsprofilen in der i-Schicht, der bei 9,45 Prozent liegt und bei denen die Zellen auf Glassubstraten erzeugt werden und das Licht von der p-Seite her eingestrahlt wird; die Stabilität der erfindungsgemäßen Zellen ist im Vergleich zu den bekannten Anordnungen aber wesentlich besser.

## Patentansprüche

1. Solarzelle mit einem aus amorphem Silizium bestehenden Halbleiterkörper der Schichtenfolge p-i-n mit einer aus Metall bestehenden, als Substrat dienenden Rückseitenkontaktelektrode (1) und mit einer aus Zinnoxid-Indiumoxid bestehenden Antireflexschicht (5), die auf der Lichteinfallseite (7) unterhalb der als Metallstreifensystem (6) ausgebildeten Vorderseitenkontaktelektrode angeordnet ist, dadurch gekennzeichnet, daß der zwischen Rückseitenkontaktelektrode (1) und Antireflexschicht (5) angeordnete Halbleiterkörper in der intrinsic-Schicht (3) ein Borprofil mit in Richtung n-Schicht (4) abnehmender Borkonzentration aufweist und daß die n-Schicht (4) der Antireflexschicht (5) benachbart ist.

2. Solarzelle nach Anspruch 1, dadurch gekennzeichnet, daß die Borkonzentration im amorphen Silizium (3) am p-i-Übergang (2, 3) von 40 ppm zum i-n-Übergang (3, 4) bis auf 0 ppm abnimmt.

## Revendications

1. Pile solaire comportant un corps semiconducteur constitué par du silicium amorphe et formé par la suite de couches p-i-n et possédant une électrode métallique (1) servant à établir un contact sur la face arrière et utilisée comme substrat et une couche antireflet (5), qui est constituée par de l'oxyde d'étain-oxyde d'indium et est disposée sur la face (7) d'incidence de la lumière au-dessous de l'électrode servant à établir un contact sur la face avant et formée par un système de bandes métalliques (6), caractérisée par le fait que le corps semiconducteur situé entre l'électrode (1) établissant le contact sur la face arrière et la couche antireflet (5), possède, dans la couche intrinsèque (3), un profil de dopage avec du bore possédant une concentration de bore qui diminue en direction de la couche de type n (4) et que la couche de type n (4) est voisine de la couche antireflet (5).

2. Pile solaire selon la revendication 1, caractérisée par le fait que la concentration de bore dans le silicium amorphe (3), qui est égale à 40 ppm au niveau de la jonction p-i (2, 3) diminue, en direction de la jonction (i-n) (3, 4) jusqu'à la valeur 0 ppm.

**Claims**

1. Solar cell comprising a semiconductor body of amorphous silicon and having the layer sequence p-i-n, comprising a back contact electrode (1) of metal, serving as a substrate, and comprising an anti-reflective layer (5) of tin oxide-indium oxide, which is arranged on the side of light incidence (7) underneath the front contact electrode, designed as a system of metal strips (6), characterized in that the semiconductor body in the intrinsic layer (3), which body is arranged between rear contact electrode (1) and anti-reflective layer (5), has a boron profile with decreasing boron concentration in the direction of the n-layer (4) and in that the n-layer (4) is adjacent to the anti-reflective layer (5).

2. Solar cell according to Claim 1, characterized in that the boron concentration in the amorphous silicon (3) at the p-i junction (2, 3) of 40 ppm decreases toward the i-n junction (3, 4) down to 0 ppm.

FIG 1

FIG 2